# EUROPÄISCHE PATENTSCHRIFT

(11) **EP 0 806 052 B1**
(45) Veröffentlichungstag und Bekanntmachung des Hinweises auf die Patenterteilung: **02.06.1999**
(21) Anmeldenummer: 95940955.8
(22) Anmeldetag: 08.12.1995
(51) Int. Cl.: H01J 37/32

(54) **PLASMAREAKTOR**
PLASMA REACTOR
REACTEUR A PLASMA

(30) Priorität: 25.01.1995 DE 19507077
(43) Veröffentlichungstag der Anmeldung: 12.11.1997
(73) Patentinhaber: FRAUNHOFER-GESELLSCHAFT ZUR FÖRDERUNG DER ANGEWANDTEN FORSCHUNG E.V., 80636 München (DE)
(72) Erfinder: WILD, Christof, D-79211 Denzlingen (DE); FÜNER, Michael, D-77948 Friesenheim (DE); KOIDL, Peter, D-79211 Denzlingen (DE)
(74) Vertreter: RACKETTE Partnerschaft Patentanwälte
(86) Internationale Anmeldenummer: DE9501786
(87) Internationale Veröffentlichungsnummer: WO9623318

(56) Entgegenhaltungen:
- EP-A- 0 438 179
- WO-A-88/10506

## Beschreibung

Die Erfindung betrifft einen Plasmareaktor zum Erzeugen und Unterhalten eines Plasmas, insbesondere zum Abscheiden von Diamant, mit einem Frequenzgenerator und mit einem von dem Frequenzgenerator über wenigstens ein Koppelelement mit elektromagnetischen Wellen gespeisten Hohlraumresonator, wobei in den von einer Wandung begrenzten Hohlraumresonator in einem Bereich hoher Feldstärke eine Reaktionseinheit einbringbar ist.

Ein derartiger Plasmareaktor ist aus der WO 88/10506 oder auch der Publikation "Diamond deposition technologies" von P.K. Bachmann und W. van Enckevort, erschienen in der Zeitschrift *Diamond and Related Materials,* Band 1, Seiten 1021 bis 1034 im Jahr 1992, bekannt. Bei diesem Plasmareaktor sind mittels eines Frequenzgenerators erzeugte Mikrowellen über einen Stiftkoppler in einen bei der WO 88/10506 zum Vergrößern des Feldes einkoppelseitig mit einem sich erweiternden Wellenleitabschnitt ausgestatteten Hohlraumresonator einkoppelbar, der durch ein endseitig geschlossenes zylindrisches Rohr als Zylinderresonator ausgebildet ist. An dem dem Stiftkoppler gegenüberliegenden geschlossenen Ende des Zylinderresonators ist eine Reaktionseinheit mit einem aus einer durch ein gezündetes Plasma gebildeten Gasphase zu beschichtendes Substrat angeordnet.

Bei dem vorbekannten Plasmareaktor hängt die Lage und Form des Plasmas sehr empfindlich von Prozeßparametern wie Gasdruck und eingekoppelter Mikrowellenleistung ab. Zudem sind diese beiden Prozeßparameter nicht unabhängig voneinander wählbar, sondern nur innerhalbb eines verhältnismäßig engen Korrelationsbereiches in gegenseitiger Abhängigkeit einstellbar. Bei einem Verlassen dieses Korrelationsbereiches tritt häufig eine sprunghafte räumliche Verschiebung des Plasmas auf, die neben einer Störung des Ablagerungsvorgangs beispielsweise ein das Substrat umgebendes, ein Reaktionsvolumen begrenzendes Quarzglas in kurzer Zeit zerstört.

Ein weiterer Nachteil des vorbekannten Plasmareaktors ist die starke Abhängigkeit der Lage des Plasmas von den geometrischen Randbedingungen und der Anordnung der Reaktoreinheit.

Aus der EP 0 438 179 A1 ist ein optischer Ofen mit einer Plasmalampe als Lichtquelle bekannt, der über einen Ellipsoidreflektor verfügt. Die Plasmalampe ist in einem Brennpunkt des Ellipsoidreflektors angeordnet, während eine Probe in dem anderen Brennpunkt positioniert ist.

Der Erfindung liegt die Aufgabe zugrunde, einen Plasmareaktor zu schaffen, der sich bei einer voneinander weitestgehend unabhängigen Wahl von Prozeßparametern wie beispielsweise Gasdruck und eingekoppelter elektromagnetischer Leistung durch ein räumlich stabiles, über die Ablagerungsfläche eines Substrates homogen verteiltes Plasma auszeichnet.

Diese Aufgabe wird erfindungsgemaß dadurch gelöst, daß der Hohlraumresonator mit einer durch Querschnittsverengungen sich in Scheitelbereichen verjüngenden Wandung ausgebildet ist, wobei der Hohlraumresonator in den Scheitelbereichen soweit verjüngt ist, daß die durch die Wandung festgelegte Feldstärkeverteilung wenigstens zwei Hauptmaxima aufweist, deren Maximalfeldstärke gegenüber den Feldstärken benachbarter Nebenmaxima überhöht ist, daß über das oder jedes Koppelelement die elektromagnetischen Wellen im Bereich eines angeordneten Hauptmaximums in den Hohlraumresonator einspeisbar sind und daß die Reaktionseinheit im Bereich eines weiteren Hauptmaximums angeordnet ist.

Durch die sich in Scheitelbereichen beispielsweise ellipsoidisch verjüngende Ausgestaltung des Hohlraumresonators ist eine Feldmode als Überlagerung von Eigenmoden mit wenigstens zwei Hauptmaxima erzeugt, die in ihrer Feldstärke deutlich über die Feldstärken benachbarter Nebenmaxima überhöht sind. Die räumliche Verteilung dieser Feldmode ist von der in den Hohlraumresonator eingekoppelten elektromagnetischen Leistung eines brennenden Plasmas und insbesondere auch von geringfügigen Deformationen in der Wandung des Hohlraumresonators weitgehend unabhängig. Bei einer Anordnung der Reaktionseinheit im Bereich eines der Hauptmaxima ist nunmehr ein räumlich stabiles und bei Variation von Prozeßparametern wie Gasdruck und/oder eingekoppelter elektromagnetischer Leistung in seiner Lage weitestgehend unbeeinflußtes sowie über einen verhältnismäßig großen Bereich homogen brennendes Plasma erzeugbar, mit dem in der Dünnschichttechnologie Hartstoff schichten, insbesondere Diamantschichten, in der Materialsynthese Plasmapolimerisations- und Pulversyntheseprozesse und in der Plasmaoberflächenbehandlung Nitrier- und Ätzbehandlungen durchführbar sind.

In bevorzugten Ausgestaltungen ist der Hohlraumresonator als Ellipsoid, als ein durch ringförmige, konische Wandsegmente abschnittsweise angeformtes, segmentiertes Ellipsoid oder als ein im Bereich eines Hauptmaximums im Durchmesser aufgeweitetes asymmetrisches Ellipsoid ausgebildet. In einer anderen Ausgestaltung sind die sich verjüngenden Bereiche als rotationssymmetrische Paraboloidabschnitte vorgesehen, die über einen Zylinderabschnitt zusammengefügt sind. Diesen Ausgestaltungen des Hohlraumresonators ist gemeinsam, daß bei Einkopplung der elektromagnetischen Leistung im Bereich eines der Hauptmaxima ein stabil brennendes Plasma im Bereich des zweiten Hauptmaximums entzündbar und unterhaltbar ist.

In einer weiteren Ausgestaltung ist der Hohlraumresonator durch zwei in Richtung der Längsachsen aneinandergefügte Ellipsoidabschnitte gebildet, wobei die Reaktionseinheit im Bereich der Stoßstelle der Ellipsoidabschnitte ein sich ausbildendes, sehr intensives Zentralmaximum einschließend angeordnet ist. Bei diesem Doppelellipsoidresonator ist die elektromagnetische Leistung an den der Reaktionseinheit gegenüberliegenden Scheitelabschnitten der Ellipsoidabschnitte einkoppelbar.

Weitere zweckmäßige Ausgestaltungen und Vorteile der Erfindung sind Gegenstand der Unteransprüche sowie der nachfolgenden Figurenbeschreibung. Es zeigen:
- Fig. 1: einen Plasmareaktor mit einer in einem Ellipsoidresonator eingebrachten Reaktionseinheit,
- Fig. 2: eine typische Feldstärkenverteilung in einem Ellipsoidresonator in einer dreidimensionalen Darstellung,
- Fig. 3: die Feldstärkenverteilung in dem Ellipsoidresonator gemäß Fig. 2 in einer Höhenliniendarstellung,
- Fig. 4: eine Teilansicht eines Plasmareaktors mit einem aus ringförmigen Wandsegmenten aufgebauten ellipsoidischen Hohlraumresonator,
- Fig. 5: eine Teilansicht eines Plasmareaktors mit einem asymmetrischen ellipsoidischen Hohlraumresonator,
- Fig. 6: eine Teilansicht eines Plasmareaktors mit einem Hohlraumresonator aus zwei sich verjüngenden Paraboloidabschnitten sowie einem zwischengefügten Zylinderabschnitt und
- Fig. 7: eine Teilansicht eines Plasmareaktors mit einem aus zwei aneinandergefügten Ellipsoidabschnitten gebildeten Hohlraumresonator.

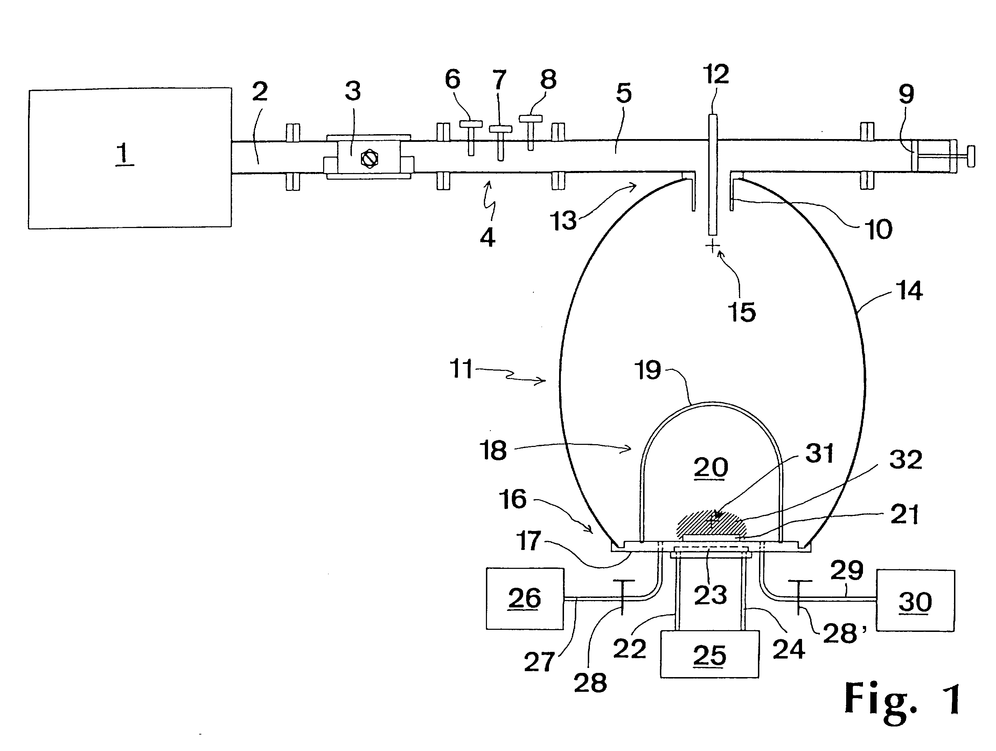

Fig. 1 zeigt einen Plasmareaktor zum Erzeugen und Unterhalten eines Plasmas, insbesondere zum Abscheiden von Diamant, mit einem Mikrowellensender 1 als Frequenzgenerator, mit dem eine elektromagnetische Welle in einer transversal-elektrischen (TE-) Mode in einen Ausgangshohlleiter 2 einkoppelbar ist. Die Frequenz der elektromagnetischen Welle liegt im Mikrowellenbereich und beträgt beispielsweise 2,45 Gigahertz. In einer Abwandlung beträgt die Frequenz etwa 915 Megahertz.

Die in dem Ausgangshohlleiter 2 geführte elektromagnetische Welle ist einem Zirkulator 3 eingespeist, mit dem Rückkopplungen reflektierter Anteile in den Mikrowellensender 1 unterdrückbar sind. Nach Durchlauf des Zirkulators 3 passiert die elektromagnetische Welle einen Impedanzwandler 4, der mit in einen Kopplungshohlleiter 5 einführbaren Abgleichstiften 6, 7, 8 ausgestattet ist. Der Kopplungshohlleiter 5 ist ein Rechteckhohlleiter, der mit einem Kurzschlußschieber 9 in Ausbreitungsrichtung der elektromagnetischen Welle abgeschlossen ist. Der Stempel des Kurzschlußschiebers 9 ist in Längsrichtung des Kopplungshohlleiters 5 verschiebbar.

Der Kopplungshohlleiter 5 weist auf einem Abschnitt in einer Seitenwand ein zylindrisches Kupplungsstück 10 auf, das in einen als Ellipsoidresonator 11 ausgebildeten Hohlraumresonator hineinragt. Der Ellipsoidresonator 11 umschließt das Volumen eines langgestreckten Ellipsoids mit zwei gleichlangen kurzen Halbachsen und ist aus einem elektrisch leitenden Material wie einer für die Hohlleiterherstellung angepaßten Aluminiumlegierung oder Messinglegierung gefertigt. Zentrisch in dem Kupplungsstück 10 ist ein den Kopplungshohlleiter 5 querender Koppelstift 12 angeordnet, der in der Längsachse des Ellipsoidresonators 11 verläuft. Der Koppelstift 12 ist zur Abstimmung in Längsrichtung verschiebbar. Der Stempel des Kurzschlußschiebers 9 ist in einer Stellung, bei der im Bereich des Koppelstiftes 12 ein Schwingungsbauch der elektromagnetischen Welle vorliegt.

Der sich in Richtung des Kupplungsstückes 10 verjüngende Scheitelbereich 13 der bezüglich der Längsachse ausgebuchteten Wandung 14 des Ellipsoidresonators 11 schließt mit dem an den Kopplungshohlleiter 5 anliegenden Abschnitt des Kupplungsstückes 10 ab, so daß der in den Ellipsoidresonator 11 hineinragende Zylinderabschnitt des Kupplungsstückes 10 mit dem Koppelstift 12 einen Koaxialhohlleiter bildet, wobei das in den Ellipsoidresonator 11 hineinragende Ende des Koppelstiftes 12 im Bereich eines einkoppelseitigen Hauptmaximums 15 einer Feldmode des Hohlraumresonators angeordnet ist.

Der dem Kupplungsstück 10 gegenüberliegende, sich verjüngende Scheitelbereich 16 des Ellipsoidresonators 11 ist an einer Abschlußplatte 17 einer Reaktionseinheit 18 angebracht. An der Abschlußplatte 17 ist eine Quarzglocke 19 als Abschluß befestigt, die in das Innere des Ellipsoidresonators 11 hineinragt und zusammen mit der Abschlußplatte 17 ein Reaktionsvolumen 20 umschließt. Innerhalb des Reaktionsvolumens 20 ist auf der Abschlußplatte 17 ein Substrat 21 aufgebracht, das mittels eines durch Kühlleitungen 22, 23, 24 durchtretenden Fluides aus einem Fluidbad 25 kühlbar ist.

In das Reaktionsvolumen 20 ist über eine an ein Vorratsbehältnis 26 angeschlossene Gaseinlaßleitung 27 ein mit einem ersten Drosselventil 28 dosierbares Reaktionsgas einleitbar, das zum Abscheiden beispielsweise von Diamant ein kohlenstoffhaltiges Gas wie CH₄ oder CO ist. Weiterhin ist mittels einer über eine Gasauslaßleitung 29 mit dem Reaktionsvolumen 20 in Verbindung stehender Vakuumpumpe 30 das Reaktionsvolumen 20 evakuierbar, wobei die Pumprate mittels eines in der Gasauslaßleitung 29 vorgesehenen zweiten Drosselventiles 28'. einstellbar ist.

Im Betrieb des Plasmareaktors baut sich in dem Hohlraumresonator eine aus überlagerten Eigenmoden gebildete Feldmode als Feldstärkeverteilung auf, die im Fall des Ellipsoidresonators 11 zwei Bereiche überhöhter Feldstärke aufweist, welche im wesentlichen um das einkoppelseitige Hauptmaximum 15 und um ein sich innerhalb des Reaktionsvolumens 20 befindliches reaktionsseitiges Hauptmaximum 31 liegen. Bei einer eingekoppelten Mikrowellenleistung von typischerweise einigen Kilowatt sowie Gasdrücken von einigen zehn Millibar zündet im Bereich des sich innerhalb des Reaktionsvolumens 20 befindlichen Hauptmaximums 31 ein Plasma 32, das das Substrat 21 umgibt. Im Falle von kohlenstoffhaltigem Reaktionsgas wächst nunmehr in Abhängigkeit der Prozeßparameter Gasdruck und eingekoppelter Mikrowellenleistung auf das Substrat 21 Diamant auf, wobei der Gasdruck über einen Bereich von typischerweise von 20 bis 300 Millibar und die Mikrowellenleistung zwischen etwa 0,5 Kilowatt bis 60 Kilowatt weitestgehend unabhängig voneinander einstellbar sind, so daß in ihrer Morphologie sehr unterschiedliche Strukturen herstellbar sind. Insbesondere bei der Verwendung einer niedrigen Frequenz der elektromagnetischen Wellen, beispielsweise den vorgenannten 915 Megahertz, ist über die Oberfläche des Substrates 21, bedingt durch die stabile Lage des reaktionsseitigen Hauptmaximums 31, ein großflächiges homogenes Plasmas erzeugt.

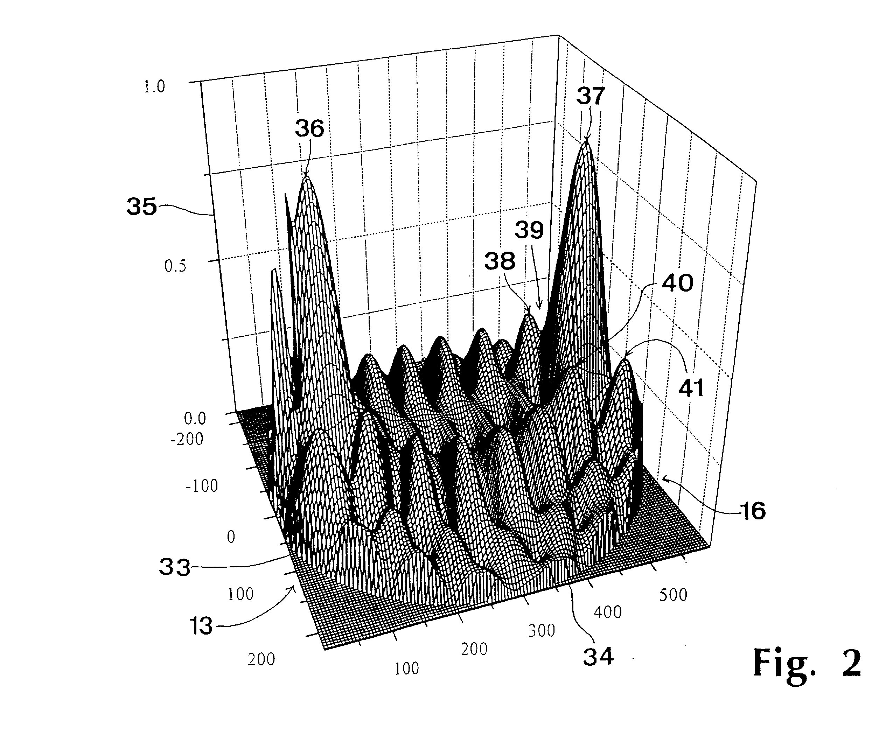

Fig. 2 zeigt in einer dreidimensionalen Darstellung die betragsmäßige elektrische Feldverteilung eines für einen Betrieb mit einer Frequenz von 2,45 Gigahertz ausgelegten Ellipsoidresonators 11 in einer Mittelebene. Auf der Querachse 33 ist symmetrisch zu dem Wert Null die radiale Position in Millimeter abgetragen. Auf der Längsachse 34 ist die axiale Position in Millimeter mit Ursprung in dem einkoppelseitigen Scheitelbereich 13 des Ellipsoidresonators 11 abgetragen. Auf der Hochachse 35 ist die betragsmäßige Feldstärke in willkürlichen Einheiten dargestellt. Der Ellipsoidresonator 11, dessen Feldverteilung in Fig. 2 gezeigt ist, hat eine Längserstreckung von etwa 60 Zentimeter und eine Quererstreckung von etwa 45 Zentimeter.

Aus der Darstellung gemäß Fig. 2 ist ersichtlich, daß sich in dem Ellipsoidresonator 11 eine elektrische Hohlraumfeldmode mit einem ausgeprägten einkoppelseitigen ersten Hauptmaximumsbereich 36 und einem intensiven, dem Hauptmaximumsbereich 36 auf der Längsachse gegenüberliegenden zweiten Hauptmaximumsbereich 37 ausbildet, wobei die Hauptmaximumsbereiche 36, 37 eine etwa um einen Faktor 3 höhere Maximalfeldstärke als benachbarte Nebenmaxima 38, 39, 40, 41 aufweisen. Dadurch ist gewährleistet, daß diese sich ebenfalls im Reaktionsvolumen 20 befindlichen Nebenmaxima 38, 39, 40, 41 bei auf den zweiten Hauptmaximumsbereich 37 angepaßten Prozeßparametern nicht zu einer Zündung des Plasmas an unerwünschten Positionen führen.

Durch die deutliche Überhöhung der Feldstärke des zweiten Hauptmaximumsbereiches 37 gegenüber den Nebenmaxima 38, 39, 40, 41 sowie die hohe räumliche Stabilität der Feldmode bei Verändern der eingekoppelten elektromagnetischen Leistung sind weiterhin die Prozeßparameter Gasdruck und Mikrowellenleistung über einen weiten Bereich unabhängig voneinander einstellbar, ohne daß es zu einer Zündung einer Plasmaentladung im Bereich der Nebenmaxima 38, 39, 40, 41 kommt. Dadurch ist zum einen eine gegenüber herkömmlichen Hohlraumresonatoren große Freiheit in der Wahl der Prozeßparameter erreicht, andererseits bleibt das Plasma an der Position des Plasmamaximums 37 auch bei Variation der eingekoppelten elektromagnetischen Leistung stabil positioniert, ohne daß es zu einem Modenspringen kommt. Weiterhin ist die Position des Plasmas 32 auch gegenüber geometrischen Modifikationen, wie sie bei dem Einbringen von verschieden ausgestalteten Reaktionseinheiten 18 auftreten, verhältnismäßig unempfindlich.

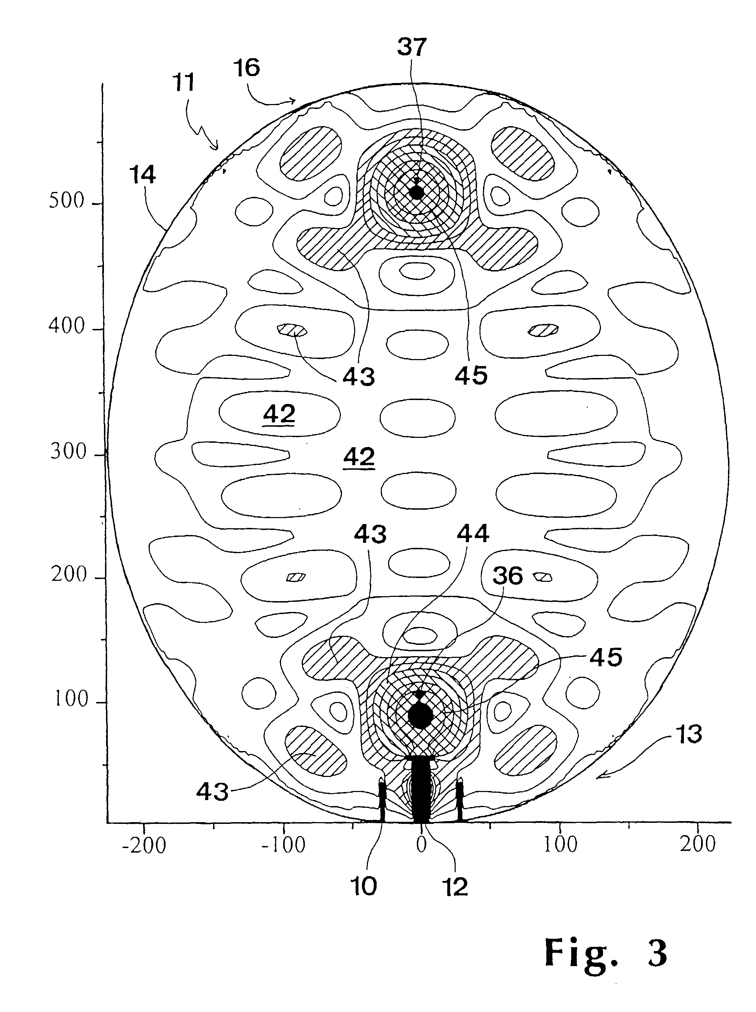

Fig. 3 zeigt die elektrische Feldstärke der Feldmode des Ellipsoidresonators 11 gemäß Fig. 2 in einer zweidimensionalen Höhenliniendarstellung. Bereiche 42 ohne Schraffur weisen in willkürlichen Einheiten eine Feldstärke von 0 bis 299 auf, in der Darstellung gemäß Fig. 3 steigend von rechts nach links schraffierte Bereiche 43 haben eine Feldstärke von 300 bis 499, von links nach rechts fallend schraffierte Bereiche 44 weisen eine Feldstärke von 500 bis 699 auf, kreuzschraffierte Bereiche 45 haben eine Feldstärke von 700 bis 899 und die schwarz ausgefüllte Spitze des ersten Hauptmaximumsbereiches 36 sowie die ebenfalls geschwärzte Spitze des zweiten Hauptmaximumsbereiches 37 weisen eine Feldstärke von 900 bis 1000 auf.

Die aus Simulationsrechnungen gewonnenen Darstellungen der Feldstärkeverteilung gemäß Fig. 2 und Fig. 3 berücksichtigen die Anordnung des Kupplungsstückes 10 sowie des Koppelstiftes 12, nicht jedoch den Einfluß der Abschlußplatte 17 mit dem aufgebrachten Substrat 21. Das Experiment sowie weitere Simulationsrechnungen haben das Vorhandensein eines zweiten Hauptmaximumsbereiches 37, das über Nebenmaxima deutlich überhöht ist, auch bei einer Modifikation in dem dem Kupplungsstück 10 gegenüberliegenden Scheitelbereich 16 des Ellipsoidresonators 11 bestätigt.

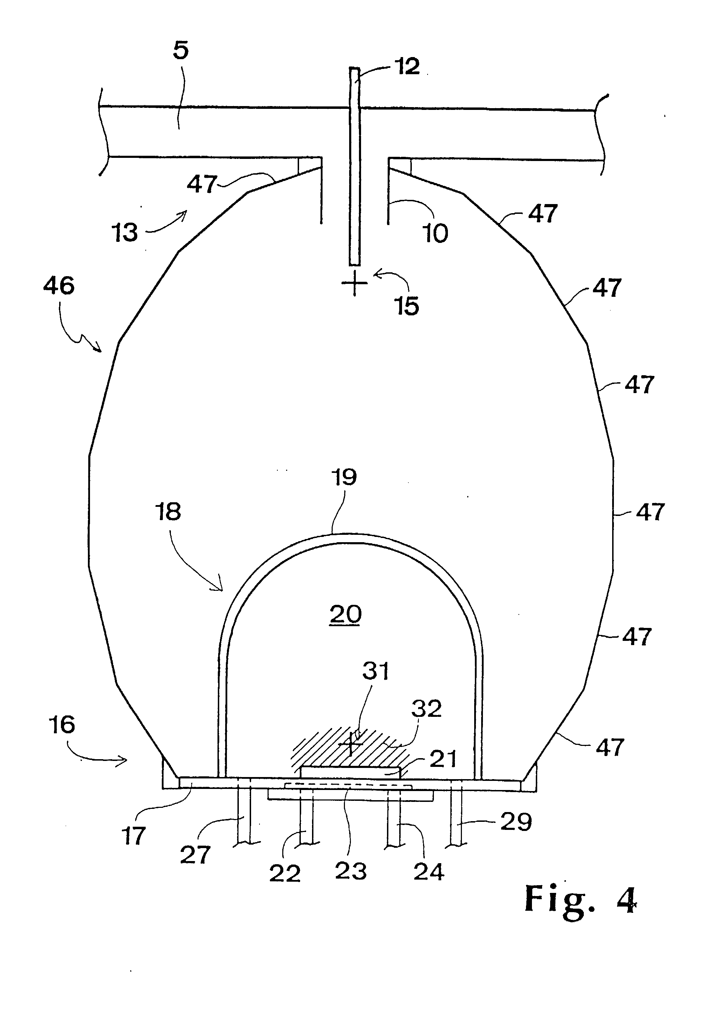

Fig. 4 zeigt in einer teilgeschnittenen Ansicht einen Teil eines Plasmareaktors gemäß Fig. 1 mit einem als ellipsoidischer Segmentresonator 46 ausgebildeten Hohlraumresonator, der aus konzentrisch um die Längsachse angeordneten ringförmigen Wandsegmenten 47 aufgebaut ist. Die Wandsegmente 47 sind in Richtung der Scheitelbereiche 13, 16 konisch zulaufende, aneinandergefügte Kegelmantelabschnittsflächen, die näherungsweise einen ellipsoidartigen Hohlraum umschließen. Der Segmentresonator 46 ist insbesondere bei niedrigen Frequenzen im Vergleich zu einstückigen Hohlraumresonatoren verhältnismäßig einfach zu fertigen, da er aus einfach herzustellenden Wandsegmenten 47 zusammenfügbar ist. Die Überhöhung der Hauptmaxima 15, 31 gegenüber den Nebenmaxima ist durch die Segmentierung nur unwesentlich beeinflußt.

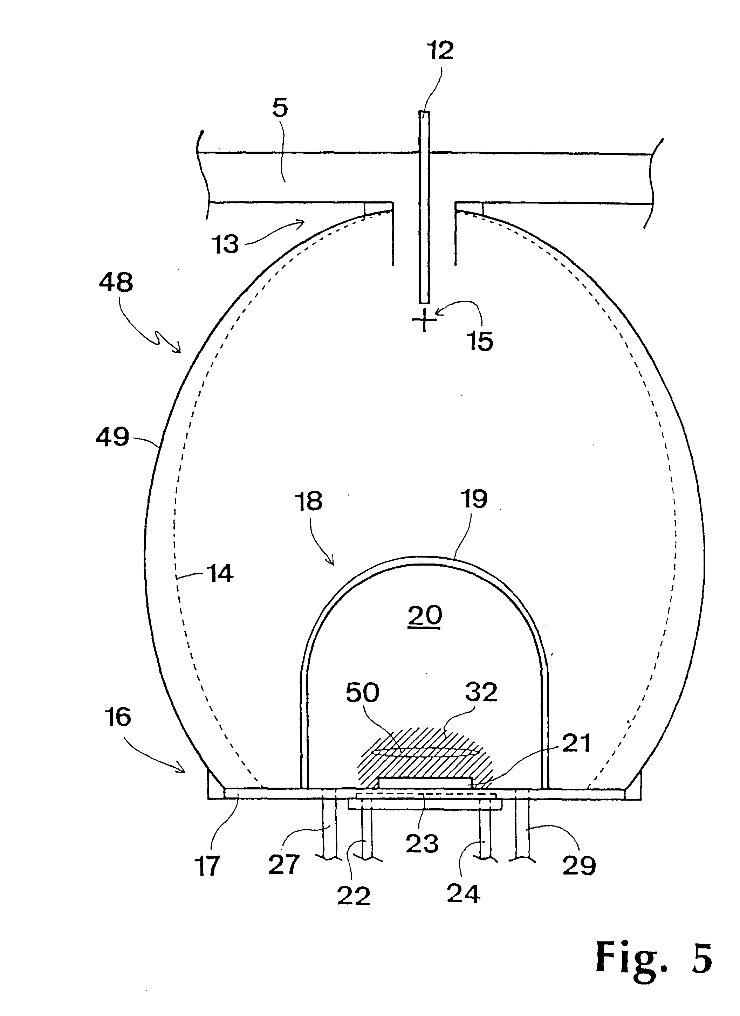

Fig. 5 zeigt in einer Teilschnittansicht einen Teil eines Plasmareaktors gemäß Fig. 1 mit einem asymmetrischen Glockenresonator 48, dessen Wandung 49 in dem sich in Richtung der Abschlußplatte 17 verjüngenden Scheitelbereich 16 gegenüber der in Fig. 5 gestrichelt dargestellten Wandung 14 eines symmetrischen Ellipsoidresonators aufgeweitet ist. Dadurch ergibt sich ein verbreitertes Hauptmaximum 50 in dem Reaktionsvolumen 20, dessen Überhöhung gegenüber Nebenmaxima zwar erniedrigt ist, eine sehr homogene Verteilung der Feldstärke in dem verbreiterten Hauptmaximum 50 über die Oberfläche des Substrates 21 führt jedoch zu gleichmäßigen Abscheidungsbedingungen aus dem Plasma 32.

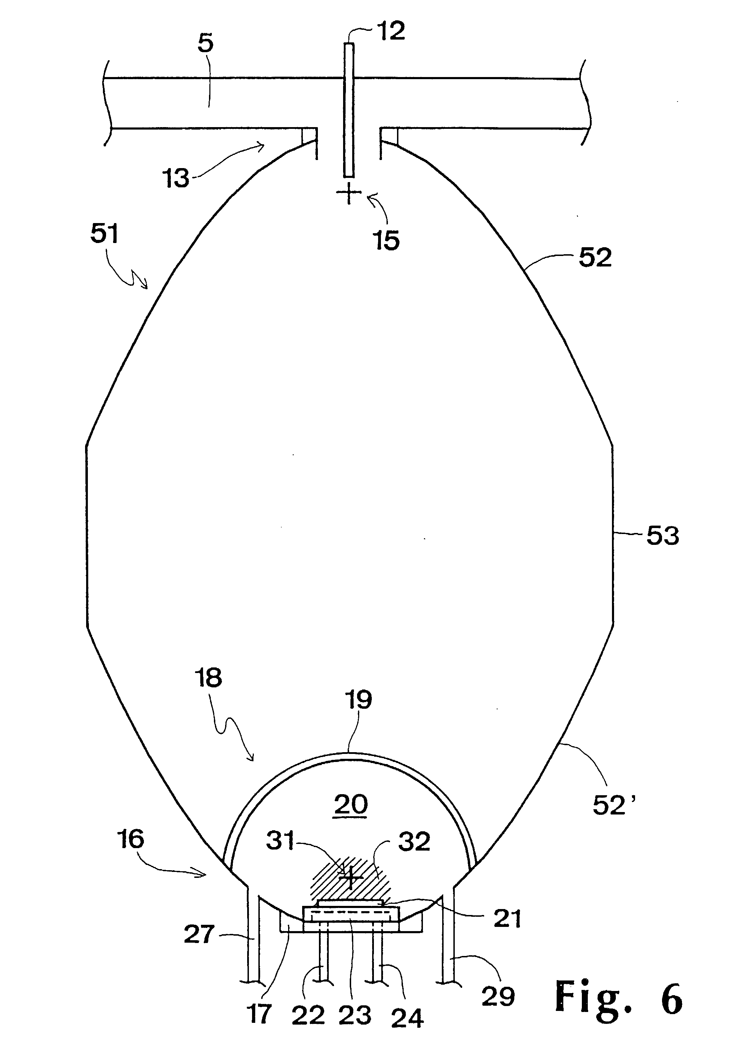

Fig. 6 zeigt im Ausschnitt einen Plasmareaktor gemäß Fig. 1 in einer Teilschnittansicht mit einem Paraboloidresonator 51, dessen Scheitelbereiche 13, 16 durch Paraboloidabschnitte 52, 52' gebildet sind. Die Paraboloidabschnitte 52, 52' sind über einen Zylinderabschnitt 53 miteinander verbunden. Bei einem Hohlraumresonator entsprechend dem Paraboloidresonator 51 ist eine starke räumliche Konzentrierung der Feldstärke im Bereich der Hauptmaxima 15, 31 erzielt.

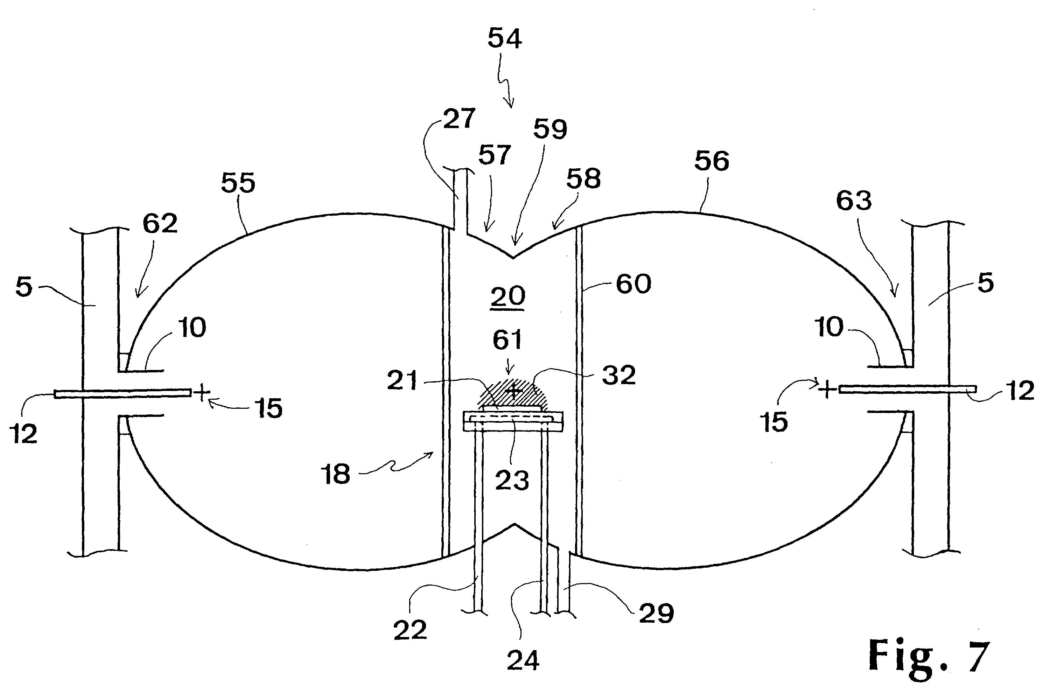

Fig. 7 zeigt in einer teilgeschnittenen Ansicht einen Plasmareaktor gemäß Fig. 1 mit einem Doppelellipsoidresonator 54, der aus zwei auseinandergefügten Wandungen 55, 56 von Ellipsoidabschnitten gebildet ist. Die aneinandergefügten, sich verjüngenden Scheitelbereiche 57, 58 der Wandungen 55, 56 bilden eine Einschnürung 59, die symmetrisch das von einem Quarzrohr 60 umschlossene Reaktionsvolumen 20 endseitig begrenzt. In der Querschnittsebene der Einschnürung 59 liegt ein aus zwei überlagerten Hauptmaxima der sich verjüngenden Scheitelbereiche 57, 58 der Ellipsoidabschnitte gebildetes Zentralmaximum 61, in dessen Umgebung das Plasma 32 zündet und das Substrat 21 beschichtbar ist.

Die Einkopplung der elektromagnetischen Leistung in den Doppelellipsoidresonator 54 erfolgt in den von dem Reaktionsvolumen 20 abgewandten Scheitelbereichen 62, 63 der Wandungen 55, 56 der Ellipsoidabschnitte. Die Einkopplung erfolgt entsprechend den vorangehend offenbarten Ausgestaltungen über jeweils einen Koppelstift 12, der jeweils einen Kopplungshohlleiter 5 quert und zentrisch auf der Längsachse des Doppelellipsoidresonators 54 in Kupplungsstücken 10 angeordnet ist sowie im Bereich eines einkoppelseitigen Hauptmaximums 15 des Doppelellipsoidresonators 54 endet. Der in Fig. 7 dargestellte Doppelellipsoidresonator 54 zeichnet sich durch eine besonders hohe elektrische Feldstärke im Bereich des Zentralmaximums 61 aus.

## Patentansprüche

1. Plasmareaktor zum Erzeugen und Unterhalten eines Plasmas (32), insbesondere zum Abscheiden von Diamant, mit einem Frequenzgenerator (1) und mit einem von dem Frequenzgenerator (1) über wenigstens ein Koppelelement (12) mit elektromagnetischen Wellen gespeisten Hohlraumresonator, wobei in den von einer Wandung begrenzten Hohlraumresonator in einem Bereich hoher Feldstärke eine Reaktionseinheit (18) einbringbar ist, **dadurch gekennzeichnet**, daß der Hohlraumresonator (11, 46, 48, 51, 54) mit einer durch Querschnittsverengungen sich in Scheitelbereichen (13, 16, 57, 58, 62, 63) verjüngenden Wandung (14, 47, 49, 52, 52', 55, 56) ausgebildet ist, wobei der Hohlraumresonator (11, 46, 48, 51, 54) in den Scheitelbereichen (13, 16, 57, 58, 62, 63) soweit verjüngt ist, daß die durch die Wandung (14, 47, 49, 52, 52', 55, 56) festgelegte Feldstärkeverteilung wenigstens zwei Hauptmaxima (15, 31, 36, 37, 50, 61) aufweist, deren Maximalfeldstärke gegenüber den Feldstärken benachbarter Nebenmaxima (38, 39, 40, 41) überhöht ist, daß über das oder jedes Koppelelement (12) die elektromagnetischen Wellen im Bereich eines angeordneten Hauptmaximums (15, 36) in den Hohlraumresonator (11, 46, 48, 51, 54) einspeisbar sind und daß die Reaktionseinheit (18) im Bereich eines weiteren Hauptmaximums (31, 37, 50, 61) angeordnet ist.

2. Plasmareaktor nach Anspruch 1, dadurch gekennzeichnet, daß der Hohlraumresonator ein bezüglich der Längsachse rotationssymmetrisches Ellipsoid (11) ist.

3. Plasmareaktor nach Anspruch 1, dadurch gekennzeichnet, daß die sich verjüngenden Bereiche bezüglich der Längsachse rotationssymmetrische Scheitelabschnitte (52, 52') eines Paraboloids sind.

4. Plasmareaktor nach einem der Ansprüche 1 bis 3, dadurch gekennzeichnet, daß zwischen sich verjüngenden Bereichen (52, 52') ein Zylinderabschnitt (53) eingefügt ist.

5. Plasmareaktor nach einem der Ansprüche 1 bis 4, dadurch gekennzeichnet, daß die Wandung des Hohlraumresonators (46) aus ringförmigen, sich konisch verjüngenden Wandsegmenten (47) aufgebaut ist.

6. Plasmareaktor nach einem der Ansprüche 1 bis 5, dadurch gekennzeichnet, daß der Hohlraumresonator (54) zwischen zwei endseitigen Scheitelbereichen (62, 63) wenigstens eine durch Querschnittsverengungen der sich in mittigen Scheitelbereichen verjüngende Wandung (55, 56) gebildete Einschnürung (59) mit wenigstens einem zwischen den endseitigen Hauptmaxima (15) gelegenen Zentralmaximum (61) der Feldstärkeverteilung aufweist, in dessen Bereich die Reaktionseinheit (18) angeordnet ist, wobei im Bereich jedes endseitigen Hauptmaximums (15) ein Koppelelement (12) vorgesehen ist.

7. Plasmareaktor nach Anspruch 6, dadurch gekennzeichnet, daß die wenigstens eine Einschnürung (59) im Bereich der Stoßstelle von Wandungen (55, 56) von Ellipsoidabschnitten ausgebildet ist.

8. Plasmareaktor nach einem der Ansprüche 1 bis 7, dadurch gekennzeichnet, daß die elektromagnetischen Wellen über eine Stiftkopplung mit einem in den Hohlraumresonator (11, 46, 48, 51, 54) ragenden Koppelstift (12) einkoppelbar sind.

9. Plasmareaktor nach Anspruch 8, dadurch gekennzeichnet, daß der Koppelstift (12) auf der Längsachse des Hohlraumresonators (11, 46, 48, 51, 54) angeordnet ist, wobei das in den Hohlraumresonator (11, 46, 48, 51, 54) ragende Ende des Koppelstiftes (12) in dem Bereich erhöhter Feldstärke eines Hauptmaximums (15, 36) angeordnet ist.

10. Plasmareaktor nach einem der Ansprüche 1 bis 9, dadurch gekennzeichnet, daß die Reaktionseinheit (18) ein Substrat (21) aufweist, das im Bereich eines Hauptmaximums (31, 37, 50, 61) angeordnet ist.

## Claims

1. A plasma reactor for generating and maintaining a plasma (32), in particular for the deposition of diamond, comprising a frequency generator (1) and a cavity resonator which is fed with electromagnetic waves by the frequency generator (1) by way of at least one coupling element (12), wherein a reaction unit (18) can be introduced into the cavity resonator which is defined by a wall, in a region of high field strength. characterised in that the cavity resonator (11, 46, 48, 51, 54) is formed with a wall (14, 47, 49, 52, 52', 55, 56) which narrows by virtue of cross-sectional constrictions in apex regions (13, 16, 57, 58, 62, 63), wherein in the apex regions (13, 16, 57, 58, 62, 63) the cavity resonator (11, 46, 48, 51, 54) is narrowed to such an extent that the field strength distribution established by the wall (14, 47, 49, 52, 52', 55, 56) has at least two main maxima (15, 31, 36, 37, 50, 61) whose maximum field strength is greatly increased with respect to the field strengths of adjacent secondary maxima (38, 39, 40, 41), that the electromagnetic waves can be fed by way of the or each coupling element (12) in the region of an arranged main maximum (15, 36) into the cavity resonator (11, 46, 48, 51, 54) and that the reaction unit (18) is arranged in the region of a further main maximum (31, 37, 50, 61).

2. A plasma reactor according to claim 1 characterised in that the cavity resonator is an ellipsoid (11) which is rotationally symmetrical with respect to the longitudinal axis.

3. A plasma reactor according to claim 1 characterised in that the narrowing regions are apex portions (52, 52') of a paraboloid, which are rotationally symmetrical with respect to the longitudinal axis.

4. A plasma reactor according to one of claims 1 to 3 characterised in that a cylinder portion (53) is inserted between narrowing regions (52, 52').

5. A plasma reactor according to one of claims 1 to 4 characterised in that the wall of the cavity resonator (46) is formed from annular, conically narrowing wall segments (47).

6. A plasma reactor according to one of claims 1 to 5 characterised in that the cavity resonator (54) has between two end apex regions (62, 63) at least one reduction portion (59) which is formed by cross-sectional constrictions of the wall (55, 56) which narrows in central apex regions. the reduction portion having at least one central maximum (61) in respect of field strength distribution, which is between the end main maxima (15) and in the region of which the reaction unit (18) is arranged, wherein a coupling element (12) is provided in the region of each end main maximum (15).

7. A plasma reactor according to claim 6 characterised in that the at least one reduction portion (59) is formed in the region of the junction of walls (55, 56) of ellipsoid portions.

8. A plasma reactor according to one of claims 1 to 7 characterised in that the electromagnetic waves can be coupled in by way of a pin coupling with a coupling pin (12) which projects into the cavity resonator (11, 46, 48, 51, 54).

9. A plasma reactor according to claim 8 characterised in that the coupling pin (12) is arranged on the longitudinal axis of the cavity resonator (11, 46, 48, 51, 54), wherein the end of the coupling pin (12), which end projects into the cavity resonator (11, 46, 48, 51, 54), is arranged in the region of increased field strength of a main maximum (15, 36).

10. A plasma reactor according to one of claims 1 to 9 characterised in that the reaction unit (10) has a substrate (21) arranged in the region of a main maximum (31, 37, 50, 61).

## Revendications

1. Réacteur à plasma pour la génération et l'entretien d'un plasma (32), en particulier pour la déposition de diamant, comportant un générateur de fréquence (1) et une cavité résonante alimentée par le générateur de fréquence (1) par l'intermédiaire d'au moins un élément de couplage (12) avec la cavité résonante alimentée par des ondes électromagnétiques, une unité de réaction (18) pouvant être introduite dans une zone de haute intensité de champ à l'intérieur de la cavité résonante délimitée par une paroi, caractérisé en ce que la cavité résonante (11,46,48,51,54) présente une paroi (14,47,49,52,52',55,56) s'amincissant en zones d'apex (13,16,57,58,62,63) par des rétrécissements de section, la cavité résonante (11,46,48,51,54) s'amincissant dans les zones d'apex (13,16,57,58,62,63) de façon que la répartition de l'intensité de champ définie par la paroi (14,47,49,52,52',55,56) présente au moins deux maxima majeurs (15,31,36,37,50,61) dont l'intensité maximale de champ dépasse les intensités de champ des maxima secondaires (38,39,40,41) voisins, en ce que les ondes électromagnétiques peuvent être injectées dans la cavité résonante (11,46,48,51,54) dans la zone où se situe un maximum majeur (15,36) par l'intermédiaire du ou de chaque élément de couplage (12), et que l'unité de réaction (18) est disposée dans la zone d'un autre maximum majeur (31,37,50,61).

2. Réacteur à plasma selon la revendication 1, caractérisé en ce que la cavité résonante est un ellipsoïde symétrique de révolution autour de l'axe longitudinal.

3. Réacteur à plasma selon la revendication 1, caractérisé en ce que les zones allant en s'amincissant correspondent aux parties culminantes (52,52') symétriques de révolution autour de l'axe longitudinal.

4. Réacteur à plasma selon l'une quelconque des revendications 1 à 3, caractérisé en ce qu'une partie cylindrique (53) est insérée entre des zones allant en s'amincissant (52,52').

5. Réacteur à plasma selon l'une quelconque des revendications 1 à 4, caractérisé en ce que la paroi de la cavité résonante (46) est formée de tronçons de paroi (47) annulaires s'amincissant en forme de cône.

6. Réacteur à plasma selon l'une quelconque des revendications 1 à 5, caractérisé en ce que la cavité résonante (54) présente entre deux zones d'apex (62,63) d'extrémité au moins un rétrécissement (59) formé par des rétrécissements de section de la paroi (55,56) s'amincissant dans des zones médianes d'apex avec au moins un maximum central (61) de la répartition de l'intensité de champ situé entre les maxima majeurs (15) d'extrémité, dans la zone duquel est disposée l'unité de réaction (18), un élément de couplage (12) étant prévu dans la zone de chaque maximum majeur (15) d'extrémité.

7. Réacteur à plasma selon la revendication 6, caractérisé en ce qu'au moins un rétrécissement (59) est conformé en portions d'éllipsoïdes dans la zone de jonction de parois (55,56).

8. Réacteur à plasma selon l'une quelconque des revendications 1 à 7, caractérisé en ce que les ondes électromagnétiques peuvent être injectées par couplage au moyen d'un couplage du type à sonde par une sonde de couplage (12) saillant dans la cavité résonante (11,46,48,51,54).

9. Réacteur à plasma selon la revendication 8, caractérisé en ce que la sonde de couplage (12) est disposée sur l'axe longitudinal de la cavité résonante (11,46,48,51,54), l'extrémité de la sonde de couplage (12) saillant dans la cavité résonante (11,46,48,51,54) étant disposée dans la zone d'intensité élevée de champ d'un maximum majeur (15,36).

10. Réacteur à plasma selon l'une quelconque des revendications 1 à 9, caractérisé en ce que l'unité de réaction (18) présente un substrat (21) disposé dans la zone d'un maximum majeur (31,37,50,61).
